# EUROPEAN PATENT APPLICATION

(11) **EP 2 605 163 A2**
(43) Date of publication of application: **19.06.2013**
(21) Application number: 12194523.2
(22) Date of filing: 28.11.2012
(51) Int. Cl.: G06F 17/50

(54) **Method of using installation guide system for air conditioner**

(30) Priority: 30.11.2011 KR 20110126780
(71) Applicant: LG Electronics, Inc., Seoul 150-721 (KR)
(72) Inventor: Cho, Sangeun, 641-711 Gyeongsangnam-do (KR); Kang, Shinae, 641-711 Gyeongsangnam-do (KR); Park, Jungyul, 641-711 Gyeongsangnam-do (KR); Lee, Haerim, 641-711 Gyeongsangnam-do (KR); Park, Mingyu, 641-711 Gyeongsangnam-do (KR)
(74) Representative: Vossius & Partner

(57) **Abstract**

A method of using an installation guide system for air conditioner is provided. The method includes: executing predetermined information to use the installation guide system for air conditioner; displaying a display unit including a drawing displaying unit; configuring driving condition information on the installation guide system; arranging apparatuses constituting an air conditioner on the drawing displaying unit; and verifying whether the air conditioner is effectively arranged.

## Description

The present disclosure relates to a method of using an installation guide system for air conditioner.

An air conditioner is a home appliance for maintaining indoor air to be in the most appropriate state according to the purposes and objectives. For example, the air conditioner adjusts indoor air to be in a cool air-conditioned state in summer, adjusts indoor air to be in a warm air-conditioned state in winter, adjusts indoor humidity, and adjusts indoor air to be in a pleasant and clean state.

In more detail, in relation to the air conditioner, a refrigeration cycle is driven to perform refrigerant compression, condensation, expansion and evaporation processes, and accordingly, an indoor space cooling or heating operation is performed.

According to whether an indoor unit and an outdoor unit are separated, such an air conditioner is divided into a separate-type air conditioner (where an indoor unit and an outdoor unit are separated from each other) and an integrated-type air conditioner (where an indoor unit and an outdoor unit are integrated into one unit). The outdoor unit includes an outdoor heat exchanger for exchanging outdoor air and the indoor unit includes an indoor heat exchanger for exchanging indoor air. The air conditioner may operate to switch to a cooling mode or a heating mode.

In relation to the air conditioner, a plurality of indoor units or outdoor units may be installed at one building. Especially, in the case of a commercial air conditioner, a high capacity outdoor unit may be arranged at the outside of a building, and indoor units may be installed at a plurality of spaces in each floor of the building.

In relation to a related art air conditioner, a proper number of outdoor units or indoor units are designed to be installed in consideration of the size and structure of a building and the building capacity.

In the process of building design, a proper number of outdoor units or indoor units are selected in consideration of the condition of the building, and also, the arrangement of a refrigerant pipe, a branched pipe, or a drain pipe and a configuration of a controller need to be considered.

However, according to a related art process of designing an air conditioner in a building, as a design drawing of the building and an installation drawing of the air conditioner follow different workflows, the drawings do not match each other. Therefore, designing a building and installing an air conditioner may not be easily performed.

Moreover, since communication between parties is not effectively made on installation information on the air conditioner (for example, building information or capacity of an air conditioner), an actually required number of indoor units or outdoor units are not installed or refrigerant pipes are not installed at the proper positions.

As mentioned above, when the air conditioner is not properly installed in a building, cooling and heating efficiencies are poor and failures occur during the use of the air conditioner.

The embodiments provide a method of using an installation guide system for air conditioner in order to guide proper installation of an air conditioner.

A method of using an installation guide system for air conditioner comprises: executing predetermined information to use the installation guide system for air conditioner; displaying a display unit including a drawing displaying unit; configuring driving condition information on the installation guide system; arranging apparatuses constituting an air conditioner on the drawing displaying unit; and verifying whether the air conditioner is effectively arranged.

Preferably, the configuring of the driving condition information comprises at least one of: generating information on a space where the air conditioner is to be installed; and designating an area of the space where the air conditioner is to be installed.

Further, the information on the space may comprise at least one of information on a building where the air conditioner is to be installed, information on floors constituting the building, and information on rooms constituting the floors.

Herein, the building, the floors, or the rooms may be available for addition and deletion.

Furthermore, generating information on the space may comprise displaying pre-determined building drawing information on the drawing displaying unit.

In addition, the designating of the area of the space where the air conditioner is to be installed may comprise designating a boundary area of a floor or a room in the drawing information displayed on the drawing displaying unit.

Moreover, the arranging of the apparatus on the drawing displaying unit may comprise arranging at least one product of an indoor unit, an outdoor unit, and a pipe on the drawing displaying unit.

Besides, the arranging of the indoor unit on the drawing displaying unit may comprise: determining a type of the indoor unit; and automatically arranging the indoor unit of the determined type on the drawing displaying unit.

The automatically arranging of the indoor unit may comprise recommending the installation number of indoor units on the basis of the information on the space where the indoor unit is to be installed.

Preferably, the arranging of the outdoor unit on the drawing displaying unit comprises: determining a type of the outdoor unit; and designating a place where the outdoor unit is to be arranged on the drawing displaying unit.

Further, the arranging of the pipe on the drawing displaying unit may comprise: displaying a main pipe that extends from the outdoor unit to an area where the indoor unit is arranged; and designating an arrangement area including the indoor unit to which the main pipe is connected.

Furthermore, the arranging of the pipe on the drawing displaying unit may comprise: extending a branched pipe from the main pipe toward the indoor unit; and arranging a branched part at a place where the branched pipe is branched from the main pipe.

In addition, the verifying of whether the air conditioner is effectively arranged may comprise performing a drawing inspection process for inspecting whether a design drawing of the air conditioner on the drawing displaying unit is effectively created.

Moreover, the performing of the drawing inspection process may comprise displaying a structure relating to a refrigerant structure connecting the apparatuses of the air conditioner, a drain structure for drainage, or a control structure.

Besides, the verifying of whether the air conditioner is effectively arranged may comprise performing a system inspection process for inspecting effectiveness of each apparatus.

The system inspection process may include: displaying information relating to positions or capacities of the apparatuses constituting the air conditioner; and/or recognizing whether the information relating to positions or capacities of apparatuses is within a limit value range of reference information.

The details of one or more embodiments are set forth in the accompanying drawings and the description below. Other features will be apparent from the description and drawings, and from the claims.

Fig. 1 is a view illustrating a configuration of an installation guide system according to an embodiment of the present invention.

Fig. 2 is a view illustrating a configuration of an installation information displaying unit according to an embodiment of the present invention.

Fig. 3 is a view illustrating a drawing displaying unit having a room area configured according to an embodiment of the present invention.

Fig. 4 is a view illustrating a configuration of an indoor type displaying unit according to an embodiment of the present invention.

Fig. 5 is a view illustrating a drawing displaying unit showing an indoor unit arrangement point according to an embodiment of the present invention.

Fig. 6 is a view illustrating a drawing displaying unit having a room area displaying unit configured and a command displaying unit during an automatic arrangement process of an indoor unit according to an embodiment of the present invention.

Fig. 7 is a view illustrating a configuration of an automatic arrangement displaying unit according to an embodiment of the present invention.

Fig. 8 is a view illustrating a configuration of an outdoor unit type displaying unit according to an embodiment of the present invention.

Fig. 9 is a view illustrating a drawing displaying unit when a main pipe is drawn according to an embodiment of the present invention.

Figs. 10 to 12 are views when a refrigerant pipe and a branched part are automatically connected besides a main pipe according to an embodiment of the present invention.

Fig. 13 is a view illustrating a configuration of an edit toolbar displaying unit according to an embodiment of the present invention.

Fig. 14 is a view illustrating a configuration of a control toolbar displaying unit according to an embodiment of the present invention.

Fig. 15 is a view illustrating a configuration of a drawing inspection displaying unit according to an embodiment of the present invention.

Fig. 16 is a view illustrating a configuration of a system inspection displaying unit according to an embodiment of the present invention.

Fig. 17 is a block diagram illustrating a configuration of an installation guide system according to an embodiment of the present invention.

Fig. 18 is a flowchart illustrating a method of using an installation guide system for air conditioner according to an embodiment of the present invention.

Reference will now be made in detail to the embodiments of the present disclosure, examples of which are illustrated in the accompanying drawings.

Hereinafter, with reference to the drawings, specific embodiments of the present invention are described. However, the scope of the present invention is not limited to the suggested embodiments, and those skilled in the art may easily suggest other embodiments within the same scope of the idea.

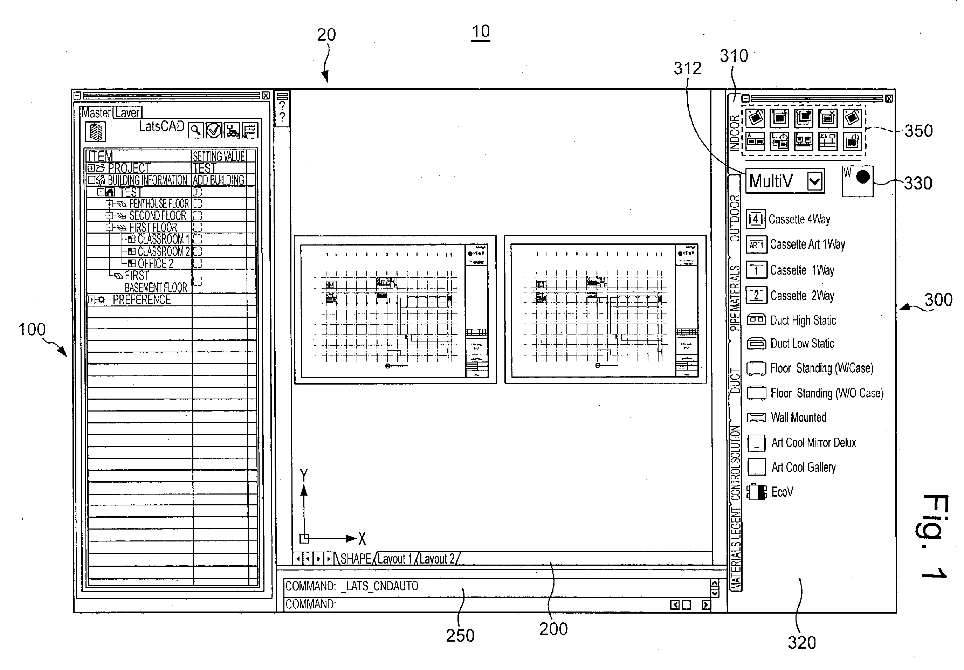

Fig. 1 is a view illustrating a configuration of an installation guide system according to an embodiment of the present invention.

Referring to Fig. 1, the installation guide system 10 includes a display unit 20 for providing a guide for installation (for example, a layout-design) of an air conditioner to a user. The display unit 20 may be displayed when predetermined information (for example, a specific program) is executed, and may be understood as a user interface for outputting required information in response to a user's command input. Here, the specific program may be executed in a PC, a terminal, a server, or a control device.

The display unit 20 includes an installation information displaying unit 100 for displaying project (for example, an installation process) information for installing an air conditioner, information (for example, building information) on an installation space where an air conditioner is installed, and preference information for configuring a system. In more detail, the installation information displaying unit 100 displays a project, building information, and a configuration as an "item", and a configuration value for each "item" at the one side of the "item". The installation information displaying unit 100 may be arranged in one partitioned area of the entire area of the display unit 20.

The display unit 20 includes a drawing displaying unit 200 for displaying information on a space having an air conditioner installed (for example, floor information or room information of a building), or arrangement information on detailed devices (or apparatuses) of an air conditioner to be installed at the building. As one example, the room information may be information on partitioned rooms at each floor of a building.

A drawing relating to a structure of a building may be displayed on the drawing displaying unit 200, and installation information on an air conditioner may be displayed on the drawing. The drawing displaying unit 200 may be displayed on another partitioned area of the entire area of the display unit 20.

A command displaying unit 250 for inputting a predetermined command relating to an air conditioner into the drawing relating to the structure of the building may be displayed on one side of the drawing displaying unit 200. The command displaying unit 250 may display characters or symbols that are inputted during a corresponding step when a user manipulates a system and a user may select displayed characters or symbols or may input new characters or symbols in order to execute a predetermined command.

The display unit 20 may include a product information displaying unit 300 for displaying information on a detailed configuration (or an apparatus) of an air conditioner to be arranged on each floor or in each room of a building. The product information displaying unit 300 may be displayed on another partitioned area of the entire area of the display unit 20.

As one example, the display unit 20 is divided into three areas and each area displays the installation information displaying unit 100, the drawing displaying unit 200, or the product information displaying unit 300. The installation information displaying unit 100 and the product information displaying unit 300 may be combined and named as a "guide display unit" in that they display various menus for arranging an air conditioner on the drawing displaying unit 200.

The product information displaying unit 300 includes a product selecting unit 310 for displaying a detailed configuration of the air conditioner. As one example, the detailed configuration of the air conditioner includes indoor units, outdoor units, pipe materials, ducts, control solutions, and materials legends.

The product information displaying unit 300 includes a list displaying unit 320 for displaying a list on a detailed configuration of the air conditioner. As one example, when an indoor unit is selected as a detailed configuration of the air conditioner, the list displaying unit 320 displays a plurality of lists according to a type of the indoor unit.

The product information displaying unit 300 may further include an edit toolbar displaying unit 350 for displaying tools for arrange, modify, or add/delete functions in icons.

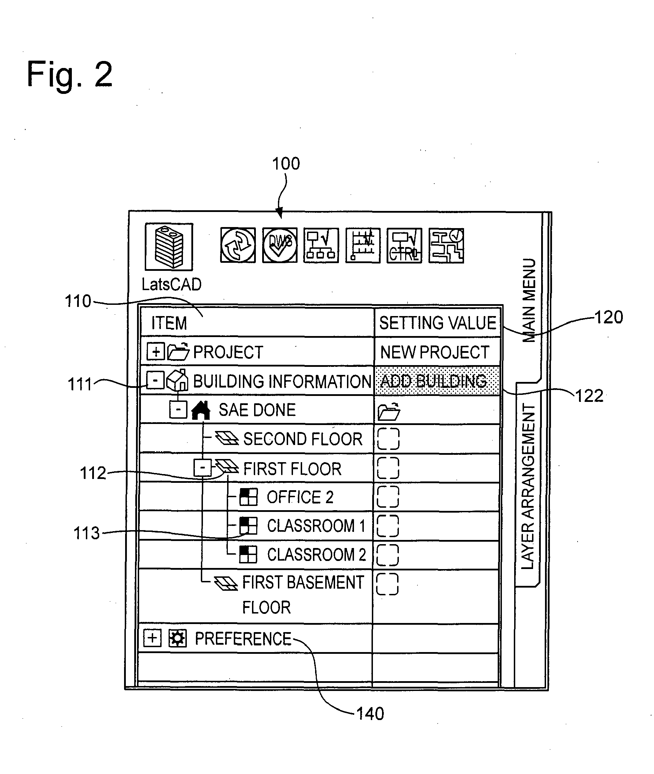

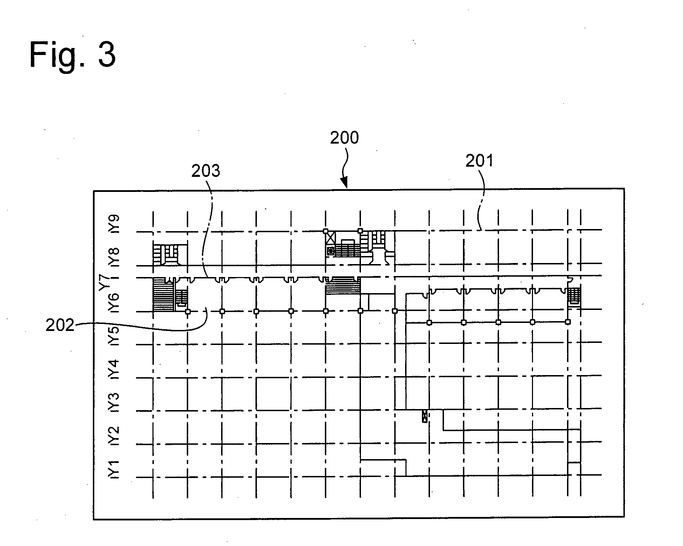

Fig. 2 is a view illustrating a configuration of an installation information displaying unit according to an embodiment of the present invention. Fig. 3 is a view illustrating a drawing displaying unit for configuring a room area according to an embodiment of the present invention.

Referring to FIG. 2, the installation information displaying unit 100 displays information (hereinafter, building information) on a building having an air conditioner installed. In the process of installing an air conditioner in a building, the installation information displaying unit 100 may be updated. Fig. 2 is a view illustrating a configuration of the installation information displaying unit 100.

The installation information displaying unit 100 includes an item displaying unit 110 for displaying items of installation information and a configuration value displaying unit 120 for displaying a configuration value of each item. In more detail, the item displaying unit 110 includes a building displaying unit 111 for displaying information on a building (for example, the name of a building), a floor displaying unit 112 for displaying information on each floor (for example, the name of a floor), and a room displaying unit 113 for displaying information on each room on a floor (for example, the name of a room).

As shown in Fig. 2, if looking at building information generated by the item displaying unit 110, the name of a building is "sae dong" and the building includes two floors above the ground and one underground floor. The first floor includes an office 2, a classroom 1, and a classroom 2.

The configuration value displaying unit 120 includes a building addition selecting unit 122 for adding a building (or a complex) to which an air conditioner is to be installed. The building addition selecting unit 122 may display selectable information such as "building addition"

When one of room names displayed on the item displaying unit 110 is selected, an information management displaying unit is displayed.

The information management displaying unit includes a " room basic information" , " load information" , " indoor unit capacity" , and "ventilation information" . The room basic information includes a floor name, a room name, a room CAD area, and room area information. If there is a difference between the room CAD area and the room area information, both areas may be adjusted to be identical to each other. When the room area designation is made (refer to FIG. 3), the room CAD area and the room area information may be generated or updated.

The load information includes a unit load relating to a cooling and heating load and actual load information. As mentioned above, the unit load may be configured in advance or newly inputted. The actual load information may be determined by the value obtained by multiplying room area information, generated or updated in a room area designation process, and a unit load. Additionally, the indoor room capacity and ventilation information may be generated or updated by an arrangement process of an indoor unit and a ventilation device.

Furthermore, the floor information displayed on the installation information displaying unit 100 and the structure drawing displayed on the drawing displaying unit 200 may be matched to each other by selecting the floor displaying unit 112.

In detail, when the floor displaying unit 112 is selected, a plurality of detailed menus are displayed. When a "floor area designation" menu is selected from the plurality of detailed menus and an area of a corresponding floor is configured on the drawing displaying unit 200, an area is matched so that it is determined that the corresponding floor corresponds to which portion on the drawing. A method of configuring an area of a corresponding floor in the drawing displaying unit 200 includes a method of dragging and configuring a computer mouse. Also, the reference point of each floor may be configured by selecting a "floor reference point configuration" menu from the plurality of detailed menus.

Furthermore, room information displayed on the installation information displaying unit 110 and a structure drawing displayed on the drawing displaying unit 200 are matched to each other by selecting the floor displaying unit 113.

In detail, when the floor displaying unit 113 is selected, a plurality of detailed menus are displayed. When a "room area creation" menu is selected from the plurality of detailed menus and an area of a corresponding room is configured on the drawing displaying unit 200, an area is matched so that it is determined that the corresponding room corresponds to which portion on the drawing.

As one example, as shown in Fig. 3, the drawing displaying unit 200 includes a first floor drawing 201 for displaying a structure of the first floor. The first floor drawing 201 includes the first room 202, which is understood as one example of a plurality of rooms. When the boundary area of the first room 202 (for example, an outer boundary line) is configured, the room area displaying unit 203 may be designated. A method of configuring an area may be identical to that of configuring a floor area.

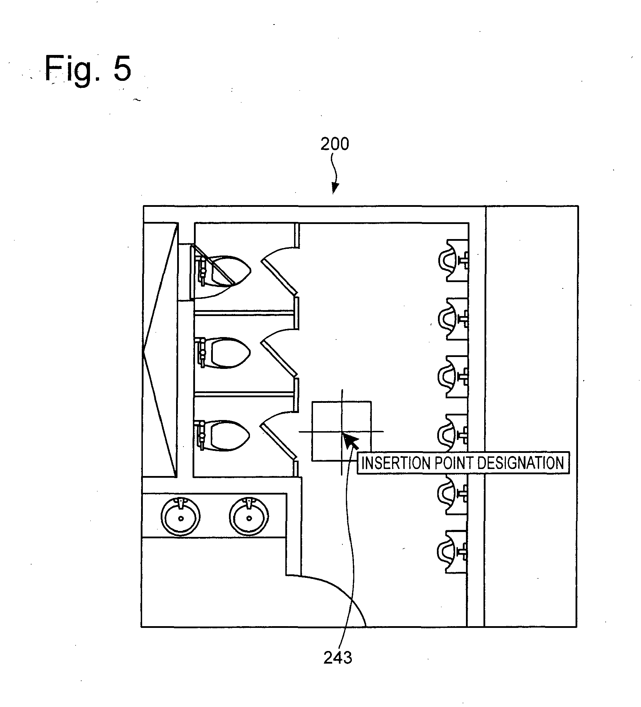

As mentioned above, when matching between information on the installation information displaying unit 100 and information on the drawing displaying unit 200 is made after floor area and room area designations are completed, as shown in Fig. 5, a configuration value displaying unit 120 displays a predetermined symbol (as one example, "R") for displaying that designation (i.e. matching) between building information and a drawing is completed. That is, a matching completion display includes "F" as a floor configuration value and "R" as a room configuration value.

After the matching is completed, as one floor is selected from a plurality of floors displayed on the floor displaying unit 112, information on a plurality of rooms in the selected floor is displayed. At this point, the displayed information on the plurality of rooms may be pop-up and may be displayed on the drawing displaying unit 200.

Moreover, while a room area designation is made through the drawing displaying unit 200, if the one floor is selected, the displayed information on the plurality of rooms includes the area and load information of each room.

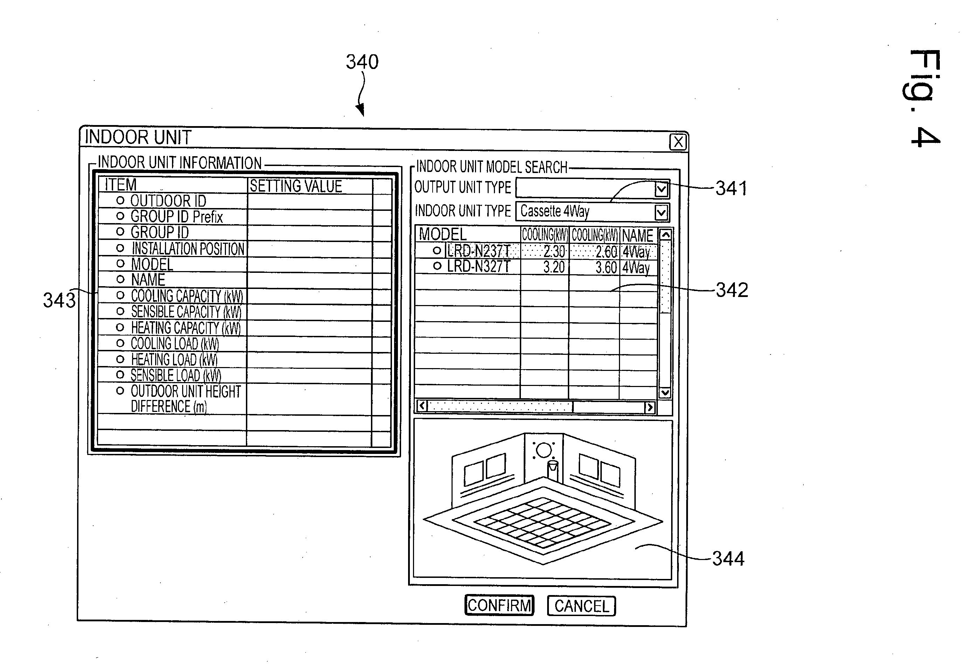

Fig. 4 is a view illustrating a configuration of an indoor unit type displaying unit according to an embodiment of the present invention. Fig. 5 is a view illustrating a drawing displaying unit for displaying an indoor unit arrangement point according to an embodiment of the present invention.

Referring to Figs. 1, 4, and 5, a process of arranging the drawing displaying unit 200 by selecting a desired type of an indoor unit will be described.

Referring to Fig. 1, a product information displaying unit 300 includes a product selecting unit 310 for selecting one of a plurality of products constituting an air conditioner such as indoor units, outdoor units, pipe materials, ducts, control solutions, and materials legends.

Also, the product information displaying unit 300 includes a category selecting unit 312 for selecting a category of the product selected by the product selecting unit 310. Here, the category may be understood as a category of an air conditioner. As one example, when an indoor unit is selected by the product selecting unit 310, the category selecting unit 312 may include "Single", "Multi/Single A", and "Multi V" types, as selectable menu.

The product information displaying unit 300 includes a list displaying unit 320 for displaying types of related indoor units on the basis of the information selected by the product selecting unit 310 and the category selecting unit 312.

The product information displaying unit 300 includes an executable automatic arrangement selecting unit 330 for automatically arranging indoor units on the drawing displaying unit 200 if the indoor units are selected as products to be installed. The automatic arrangement selecting unit 330 may be activated only when an "indoor unit" is selected by the product selecting unit 310.

When at least one indoor unit is selected by the list displaying unit 320, as shown in Fig. 4, the display unit 20 displays an indoor unit type displaying unit 340.

The indoor unit type displaying unit 340 includes a type displaying unit 341 for displaying a type of an indoor unit selected by the list displaying unit 320, a model displaying unit 342 for displaying the indoor unit model corresponding to the indoor unit type, and a shape displaying unit 344 for displaying the shape of an indoor unit to be selected.

The type displaying unit 341 may include a plurality of selectable types, and changing into or selecting different types may be possible. When one of a plurality of types in the type displaying unit 341 is selected, at least one model name corresponding to the selected type is displayed on the model displaying unit 342. Moreover, the shape displaying unit 344 displays the shape of the selected model, that is, one model of the plurality of models.

The indoor unit type displaying unit 340 includes an indoor unit information displaying unit 343 for displaying a detailed configuration of the air conditioner. That is, the indoor unit information displaying unit 343 may display information corresponding to an indoor unit of the model selected by the model displaying unit 342. As one example, the information may include the model, name, cooling and heating capacity, and cooling and heating load of an indoor unit.

After the type and model of an indoor unit are selected, as a "confirm" button is inputted, an indoor unit to be arranged may be determined.

When one model for an indoor unit is selected through the indoor unit type displaying unit 340, the indoor unit of the selected model may be arranged on the drawing displaying unit 200. In more detail, a user selects one point of the drawing displaying unit 200, and then, recognizes an indoor unit arrangement point 243. As one example, one point where an indoor unit is to be arranged may be selected using a computer mouse. Once the indoor unit arrangement point 243 is recognized, an indoor unit determined in Fig. 4 is inserted into the drawing displaying unit 200.

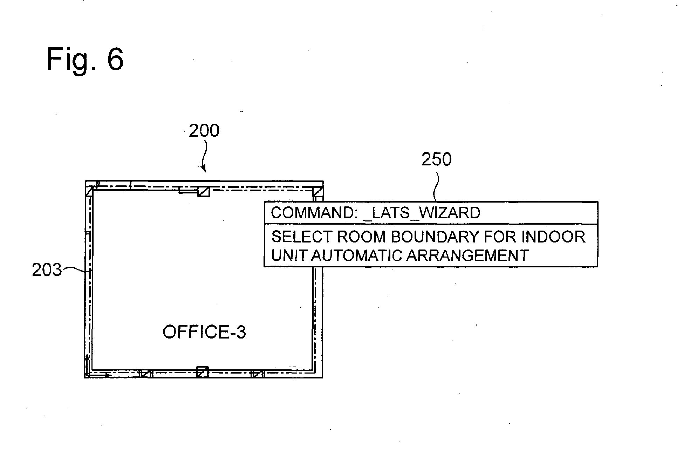

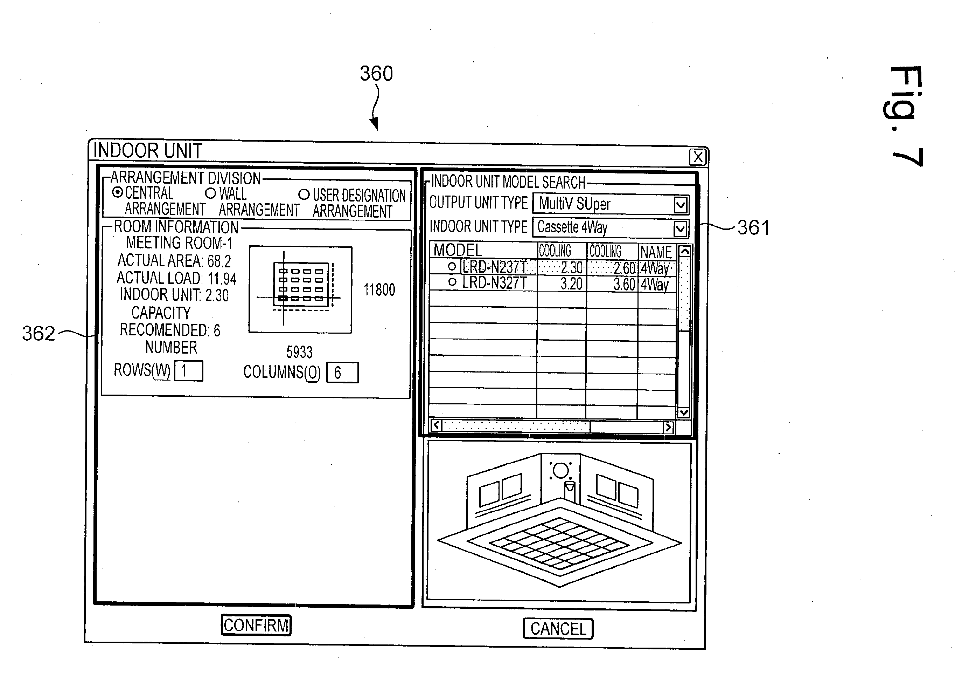

Fig. 6 is a view illustrating a drawing displaying unit where a room area displaying unit is configured and a command displaying unit during an automatic arrangement process of an indoor unit according to an embodiment of the present invention. Fig. 7 is a view illustrating a configuration of an indoor unit automatic arrangement displaying unit according to an embodiment of the present invention. Referring to Figs. 6 and 7, an automatic arrangement process of an indoor unit will be described.

When the automatic arrangement selecting unit 330 of the product information displaying unit 300 is selected, as shown in Fig. 6, the command displaying unit 250 displays a message "select the boundary for automatic arrangement of an indoor unit".

A user may select a room (space) area where an indoor unit is to be arranged among at least one room listed in the drawing displaying unit 200, on the basis of such a message. As mentioned above, a room area displaying unit 203 may be generated by designating the outer area of a room with a mouse.

Then, when the automatic arrangement selecting unit 330 is selected again, as shown in Fig. 7, the display unit 20 displays an indoor unit automatic arrangement displaying unit 360. The indoor unit automatic arrangement displaying unit 360 includes a model displaying unit 361 for selecting the type and model of a desired indoor unit for arrangement, and an arrangement information displaying unit 362 for displaying arrangement information on the indoor unit of the selected model.

The arrangement information displaying unit 362 includes an "arrangement division displaying unit" for selecting whether an indoor unit is arranged at the center or wall of a room and a "room information displaying unit" for displaying information on a room where an indoor is to be arranged.

The room information displaying unit may recommend how many indoor units are optimal for installation in consideration of room area, load information, and the capacity of a corresponding indoor unit. That is, the room information displaying unit may display the recommended number of selected indoor units. Also, the room information displaying unit may display information on how to arrange indoor units, that is, arrangement information.

Accordingly, because of the capacity of an indoor unit, room area, and load information, a user does not need to worry about how many indoor units are arranged and how to arrange indoor units. Therefore, easy-of-use may be enhanced.

When an indoor unit model is selected through the indoor unit automatic arrangement displaying unit 360 and a confirm button is inputted, a user may configure a reference point where an indoor unit is arranged on the drawing displaying unit 200. Also, on the basis of the configured reference point, an indoor unit may be automatically arranged.

Thus, once the type and model of an indoor unit to be arranged are selected, since the indoor unit is automatically arranged in the designated room, a user does not need to arrange indoor units one by one in the drawing displaying unit 200.

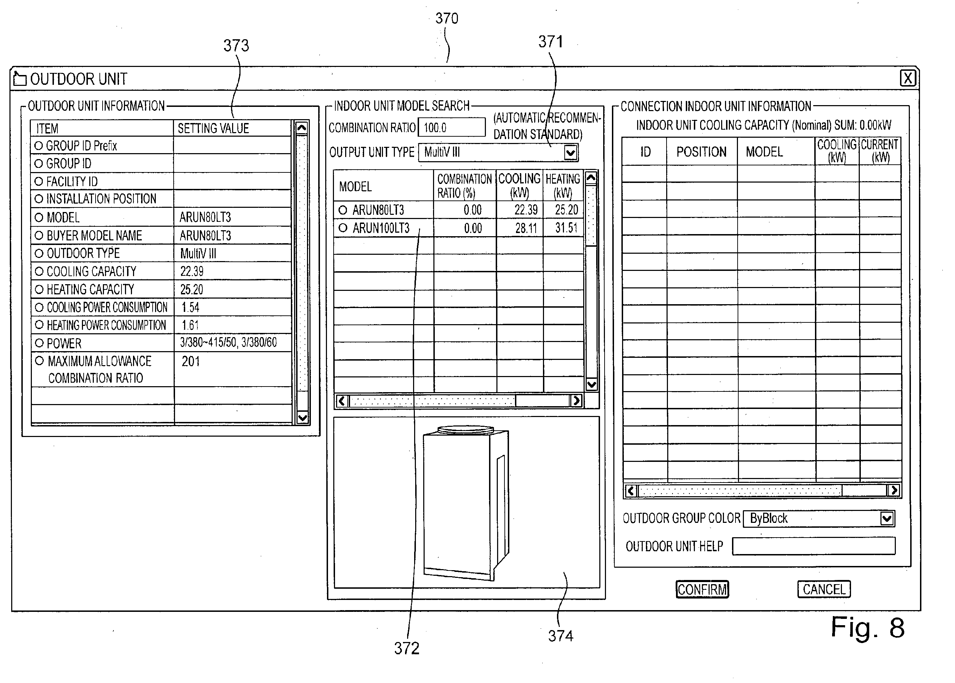

Fig. 8 is a view illustrating a configuration of an outdoor unit type displaying unit according to an embodiment of the present invention.

When an outdoor unit is selected by the product selecting unit 310, the product information displaying unit 300 displays a category selecting unit 312 for displaying a category of an air conditioner and a list displaying unit 320 for displaying types of an output door unit. Then, when one is selected from at least one outdoor unit displayed on the list displaying unit 320, as shown in Fig. 8, the display unit 20 displays an outdoor unit type displaying unit 370.

The outdoor unit type displaying unit 370 includes a type selecting unit 371 for selecting the type of an outdoor unit, a model displaying unit 372 for displaying the model of a selected output door type, an outdoor unit information displaying unit 373 for displaying information relating to an outdoor unit of a model selected by the model displaying unit 372, and a shape displaying unit 374 for displaying the shape of the selected model.

Also, the outdoor unit type displaying unit 370 may display information on an indoor unit connected to a selected outdoor unit. The connection indoor unit information may be generated or updated during an installation guide process of an air conditioner.

After the type and model of an outdoor unit are selected, as a "confirm" button is inputted, an outdoor unit to be arranged may be determined.

Moreover, the product selecting unit 310 includes "pipe materials" as a products type. When the pipe materials are selected, the list displaying unit 320 displays a list of materials relating to a pipe connecting an indoor unit with an outdoor unit.

The list displaying unit 320 includes "riser hole". The "riser hole" may be understood as a pipe material connecting a floor with another floor. When the "riser hole" is selected, a riser hole arrangement displaying unit (not shown) may be displayed.

The riser hole arrangement displaying unit includes riser hole/ down hole information. The riser hole/down hole information includes a "riser hole division displaying unit" for selecting a refrigerant pipe and a drain pipe as the type of a pipe, and a " top floor displaying unit" and a "bottom floor displaying unit" for selecting top floor and bottom floor information. After information for the riser hole/down hole is inputted and a confirm button is pressed, riser hole information is configured.

Also, a user may select one point of a structure drawing, which represents a specific floor on the drawing displaying unit 200, as a reference point. Once the reference point is selected, the riser hole may be arranged at the same position by each floor on the basis of the configured riser hole information.

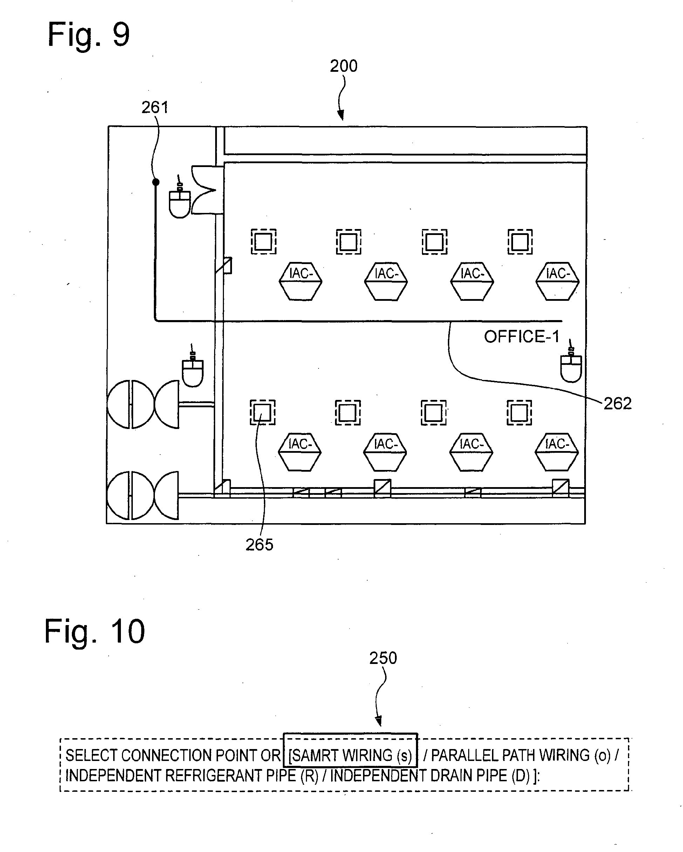

Fig. 9 is a view illustrating a drawing displaying unit when main pipe is drawn according to an embodiment of the present invention. Figs. 10 to 12 are views when a refrigerant pipe and a branched part are automatically connected besides the main pipe according to an embodiment of the present invention.

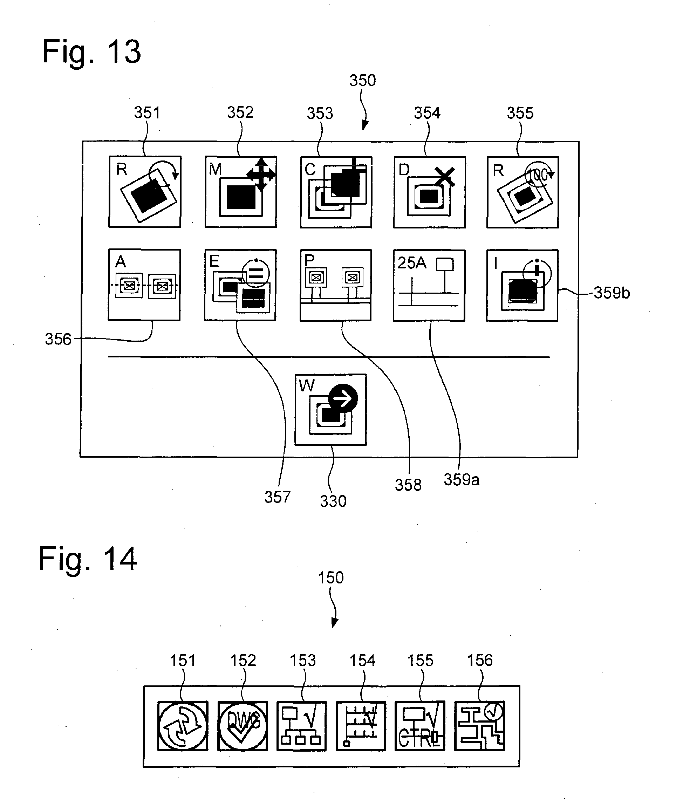

As described above, when an indoor unit and an outdoor unit are arranged, the main pipe may be configured as a refrigerant pipe connecting an indoor unit with an outdoor unit. First, when a wiring tool 358 (refer to Fig. 13) in the edit toolbar displaying unit 350 is selected, the drawing displaying unit 300 switches into a pipe drawing available state.

In more detail, referring to Fig. 9, an indoor unit 265 and an output door unit arrangement point 261 are displayed on the drawing displaying unit 200. A user may configure the main pipe line 262 from the outdoor unit arrangement point 261 or a riser hole reference point (not shown) toward an area where the indoor unit 265 is arranged. As one example, by drawing a bending line with a mouse, the main pipe line 262 may be displayed.

Also, the command displaying unit 250 displays a message for selecting smart wiring S. A user selects the smart wiring, for example, inputs "S" on a command window, in order to input a smart wiring command.

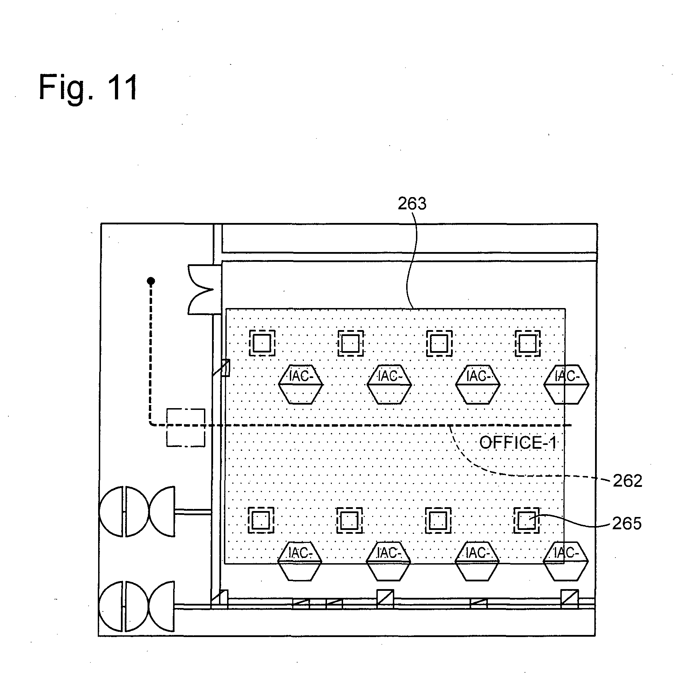

After the smart wiring command is inputted, as shown in Fig. 11, the main pipe line 262 displayed on the drawing displaying unit 200 is selected and an indoor unit arrangement area is designated. The indoor unit arrangement area is understood as an area including indoor units 265 to which the main pipe is to be connected. That is, an indoor unit connection area configuring unit 263 for including the indoor unit 265 therein may be configured on the drawing displaying unit 200.

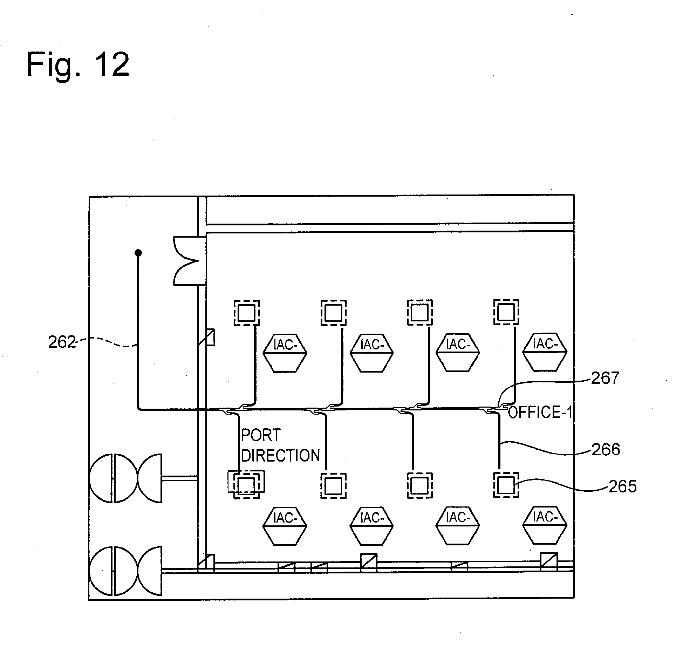

When the indoor unit connection area configuring unit 263 is configured (displayed), as shown in Fig. 12, a branched pipe 266 automatically extends from the main pipe line 262 toward the indoor units 265. Also, the branched part 267 is automatically arranged at the point where the branched pipe 266 is branched from the main pipe line 262.

Moreover, whether to extend the branched pipe may be determined according to a state of a pipe end connection in the preference displaying unit 140 (refer to Fig. 2). When a refrigerant pipe is configured as a "Normal" state through a detailed menu of the pipe end connection, as shown in Fig. 12, the branched pipe 266 is inserted from the main pipe line 262 so that an indoor unit is connected.

Furthermore, when the refrigerant pipe is configured as a "Direct" state, unlike Fig. 12, the branched pipe 266 is directly inserted into an indoor unit from the main pipe line 262.

Thus, when the main pipe line is configured after an indoor unit and an outdoor unit are selected, an arrangement structure in which an indoor unit is connected from the main pipe line may be automatically formed. Therefore, easy of use is excellent.

However, unlike the above description, when the smart wiring command is not inputted, by directly selecting the branched pipe of the list displaying unit 320, the branched pipe may be inserted into the drawing displaying unit 200.

Moreover, although not shown in the drawing, a drain pipe besides the refrigerant pipe may be arranged on the drawing displaying unit 200. The drain pipe may extend or be arranged in a direction parallel to the refrigerant pipe.

In more detail, after the wiring tool 358 is selected, a parallel path wiring O displayed on the command displaying unit 250 may be selected. Then, after a reference pipe (a reference cooling pipe) to follow a parallel path (direction) is designated, an offset direction is configured. Then, a drain pipe is connected along the main pipe line 252 with a predetermined offset. Here, the offset distance may be configured or changed through a "pipe offset" included in the preference displaying unit 140.

Fig. 13 is a view illustrating a configuration of an edit toolbar displaying unit according to an embodiment of the present invention.

Referring to Fig. 13, the edit toolbar displaying unit 350 includes a rotate tool 351. The rotate tool 351 allows an object, for example, the detailed products or apparatuses (materials) constituting an air conditioner, to rotate in a specific direction when the object is arranged on the drawing displaying unit 200. An icon representing the rotate tool 351 and the object are sequentially selected and a rotation direction or rotation value is inputted, so that the object may rotate in a desired direction.

The edit toolbar displaying unit 350 includes a move tool 352. The move tool 352 moves the object from the reference point to the selection point. An icon representing the move tool 352 and the object are sequentially selected and the reference point and the movement point are selected (or inputted), so that the object may move. At this point, when the object is connected to another object, it remains connected as the object moves.

The edit toolbar displaying unit 350 includes a copy tool 353. The copy tool 353 may be selected when a specific object is to be copied. As one example, when a plurality of objects is inserted into the drawing displaying unit 200, the copy tool 353 may be used.

The edit toolbar displaying unit 350 includes a delete tool 354. The delete tool 354 deletes the object. An object may be deleted by sequentially selecting an icon representing the delete tool 354 and the object, i.e. a target to be deleted.

The edit toolbar displaying unit 350 includes a reverse rotate tool 355. The reverse rotate tool 355 rotates an object in a 180° direction. An object may rotate at 180° by sequentially selecting an icon representing the reverse rotate tool 355 and the object, i.e. a target to be rotated.

The edit toolbar displaying unit 350 includes an align tool 356. The align tool 356 is used to align objects in a vertical or parallel direction. Objects may be aligned in a designated direction by sequentially selecting an icon representing the align tool 356 and the objects, i.e. targets to be aligned, and designating an alignment direction (a vertical or parallel direction). Then, as a selectable alignment option, object uniform arrangement may be included in a submenu of the align tool 356.

The edit toolbar displaying unit 350 includes a match tool 357. The match tool 357 is used to match object attribute information. When an icon representing the match tool 357 and a plurality of objects, i.e. matching targets to icons, are sequentially selected, an attribute of a first selected device may be reflected (matched) on a second selected device.

The edit toolbar displaying unit 350 includes a wiring tool 358. The wiring tool 358 may be used to perform wiring on a refrigerant pipe or a drain pipe on the basis of a port of an object (for example, an indoor unit or an outdoor unit). After an icon representing the wiring tool 357 is selected, an object or a port is designated, so that wiring may be performed manually, or a wiring option (for example, smart wiring, and parallel path wiring) may be selected.

The edit toolbar displaying unit 350 includes an annotation tool 359a. The annotation tool 359a is used to generate an annotation on an object. After an icon representing the annotation tool 359a is selected and a pipe or riser hole is selected for annotation, its position and path may be designated.

The edit toolbar displaying unit 350 includes an attribute tool 359b. The attribute tool 359a is used to confirm attribute information on an object. After an icon representing the attribute tool 359a is selected, an object, i.e. a target for attribute information, may be selected for execution.

As one example, when the attribute tool 359a is selected and an indoor unit or an outdoor unit in the drawing displaying unit 200 is selected, the indoor unit type displaying unit 340 or the outdoor type displaying unit 370 in FIG. 4 or 8 is displayed. At this point, information displayed on the indoor unit type displaying unit 340 or the outdoor type displaying unit 370 may be changed.

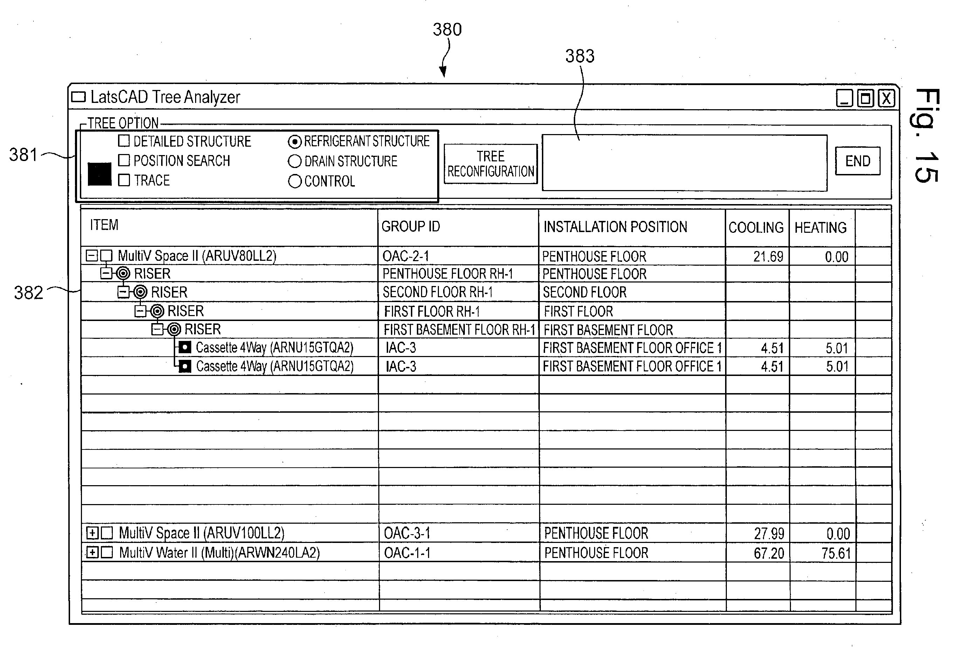

Fig. 14 is a view illustrating a configuration of a control toolbar displaying unit according to an embodiment of the present invention. Fig. 15 is a view illustrating a configuration of a drawing inspection displaying unit according to an embodiment of the present invention.

Referring to Fig. 14, the installation information displaying unit 100 includes a selectable control toolbar displaying unit 150 for performing a system inspection.

In more detail, the control toolbar displaying unit 150 includes a refresh selecting unit 151 for updating installation information on an air conditioner, for example, connection information on detailed product or apparatus (device). When the refresh selecting unit 151 is selected, the drawing on a building structure may be matched (synchronized) to the installation information on an air conditioner configured through the system 10.

The control toolbar displaying unit 150 includes a drawing inspection selecting unit 152 for displaying drawing information realized in the system 10, for example, a connection structure of an indoor unit and an outdoor unit, and inspecting whether there is any error.

When the drawing inspection selecting unit 152 is selected, as shown in Fig. 15, the display unit 20 displays a drawing inspection displaying unit 380.

The drawing inspection displaying unit 380 includes an option selecting unit 381 for selecting the type of a structure (tree) to be displayed, a drawing configuration information displaying unit 383 for displaying information on the structure selected by the option selecting unit 381, and an error information displaying unit 383 for displaying whether there is any error on a connection configuration of a corresponding structure.

In the option selecting unit 381, selectable "detailed structure", "position search", and "trace" buttons are included as one group, and "refrigerant structure", "drain structure", and "control" buttons are included as another group. Also, the option selecting unit 381 may further include a selectable input unit called a "tree configuration".

When a detailed structure is selected by the option selecting unit 381, one of the refrigerant structure, the drain structure, and the control button is selected, and then, a tree reconfiguration is inputted, a detailed structure corresponding to each structure is displayed on the drawing configuration information displaying unit 382. In Fig. 15, as one example, a detailed structure for a refrigerant structure is displayed. The detailed structure includes a refrigerant structure from an outdoor unit to a riser hole and an indoor unit.

If there is an error in the refrigerant structure, (as one example, the main pipe described in Fig. 9 may not be properly formed, or a part of the main pipe is disconnected), the error information displaying unit 383 displays a message for "one connection configuration error occurs and check the list". Also, a list of the corresponding apparatus that generates an error may be displayed with a specific color or may be displayed to blink in order to make error checking easy.

Furthermore, the control toolbar displaying unit 150 further includes a selectable drain pipe check selecting unit 154 for confirming a drain pipe connection structure. When the drain pipe check selecting unit 154 is selected, a drain structure of the drawing inspection displaying unit 380 may be activated. Also, the diameter of a drain pipe is automatically configured, so that it may be annotated on the drawing displaying unit 200.

Furthermore, the control toolbar displaying unit 150 further includes a selectable control check selecting unit 155 for confirming a control line of an air conditioner. When the control check selecting unit 155 is selected, a control button of the drawing inspection displaying unit 380 may be activated. The drawing inspection displaying unit 380 displays a cable length on the basis of the central control line of an air conditioner and also quantity information on indoor units connected to a controller.

The control toolbar displaying unit 150 further includes a selectable duck check selecting unit 156 for selecting the diameter of a duck and a subsidiary model and calculating pressure loss values. Also, the drawing relating to the arrangement of a duct may be automatically inserted into the drawing displaying unit 200.

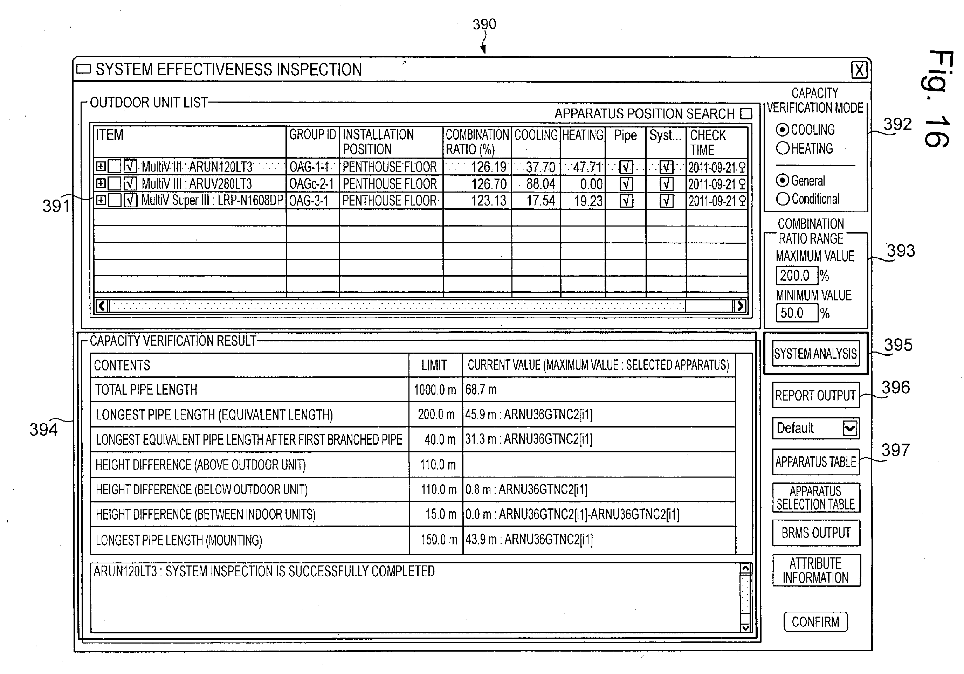

Fig. 16 is a view illustrating a configuration of a system inspection displaying unit according to an embodiment of the present invention.

Referring to Figs. 14 and 16, the control toolbar displaying unit 150 includes a selectable system inspection selecting unit 153 for confirming a system verification result value for each apparatus.

When the system inspection selecting unit 153 is selected, as shown in Fig. 16, the display unit 20 displays a system inspection displaying unit 390.

The system inspection displaying unit 390 includes an inspection item displaying unit 391 for displaying an indoor unit based apparatus list, a verification mode selecting unit 392 for selecting a verification required system mode, a combination range configuring unit 393 for configuring a combination ratio range of an indoor unit and an indoor unit, and a verification result displaying unit 394 for displaying a verification result of a system. Here, the combination ratio range is a ratio of an indoor capacity to an outdoor capacity, and the range of the maximum value and the minimum value may be configured.

Also, the system inspection displaying unit 390 may further include a plurality of selectable input units. The plurality of input units include a system analysis selecting unit 395 for requesting a system analysis, a report output selecting unit 396 for outputting design information on an air conditioner in a report form, and an apparatus table selecting unit 397 for outputting information on apparatuses and pipes applied to a design drawing in a table form.

Also, the inspection item displaying unit 391 may further include the group ID, installation position, combination ratio, and cooling and heating capacity of an outdoor unit. Also, the inspection item displaying unit 391 includes a check box for displaying a plurality of outdoor units applied to a design drawing, and selecting at least one outdoor unit for system analysis

After at least one outdoor unit is selected through the check box, when the system analysis selecting unit 395 is selected, an analysis time (a check time) at which an analysis is performed and also a display representing whether an analysis is completed are sequentially displayed depending on the time elapsed. This display is displayed on the inspection item displaying unit 391 as an item such as Pipe (being analyzed) and Syst.(analysis completed).

Also, a capacity verification result may be further displayed on the verification result displaying unit 394. The verification result contents include information relating to a pipe length and information relating to a height difference between an outdoor unit and an indoor unit.

As one example, the verification result contents may include "a total pipe length", "the longest pipe length (equivalent length)" "the longest pipe length after the first branched pipe", "a height difference (above an outdoor unit), "a height difference (below an indoor unit)", "a height difference (between indoor units)", and "the longest pipe length (mounting)".

Also, the limit and current value relating to the contents of the verification result information are displayed on the verification result displaying unit 394. That is, the limit and current value are displayed to be compared.

If the current value is within the limit value and the combination ratio and the cooling and heating capacity are within a configuration range, an air conditioner is understood as being successfully installed. In this case, for example, without an error message, a message "system inspection is successfully completed" is displayed on the verification result displaying unit 394.

On the other hand, if the current value is out of the limit value, or the combination ratio is out of the range of the combination range configuring unit 393, or the cooling and heating capacity is less than an actual load, a message for representing that an error occurs in design information of an air conditioner may be outputted. Here, the actual load is a determined value on the basis of the area of a room where an air conditioner is to be installed and sensible heat generation.

As one example, when the combination ratio is out of the range that the combination range configuring unit 393 configures, an error message "a combination ratio is out of a configuration range" may be displayed. Also, if the cooling and heating capacity of the indoor unit are less than the actual load, a message "cooling load of (specific) room at (specific) floor : indoor unit capacity (6.00KW) < actual load (10.78KW) is less than the reference value" may be outputted. Also, a list of the corresponding apparatus that generates an error may be displayed with a specific color or may be displayed to blink in order to make error checking easy.

While system inspection is successfully completed, if the report output selecting unit 396 is selected, the display unit 20 displays a report item displaying unit (not shown). The report item displaying unit includes an output item selecting unit for selecting items that are included in a report to be outputted and a user may check desired items and then may press a confirm button.

Once the confirm button is inputted, a report (not shown) is displayed. The report includes installation information on an air conditioner. The installation information on the air conditioner includes information on an indoor unit, an outdoor unit, and a ventilation unit, for example, information on the type, quantity, cooling and heating capacity, power consumption, or access port size of each apparatus. Such a report may be delivered to a customer (such as building owners and architects).

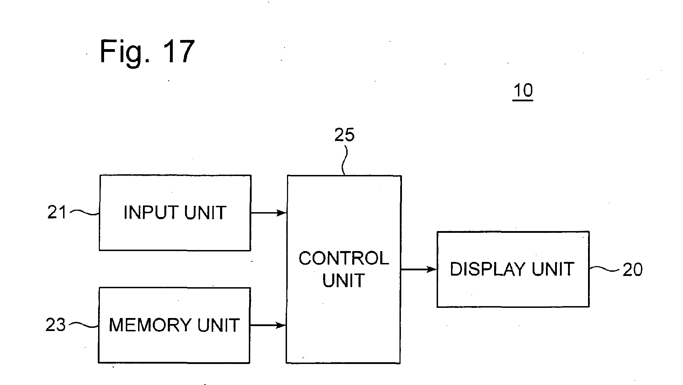

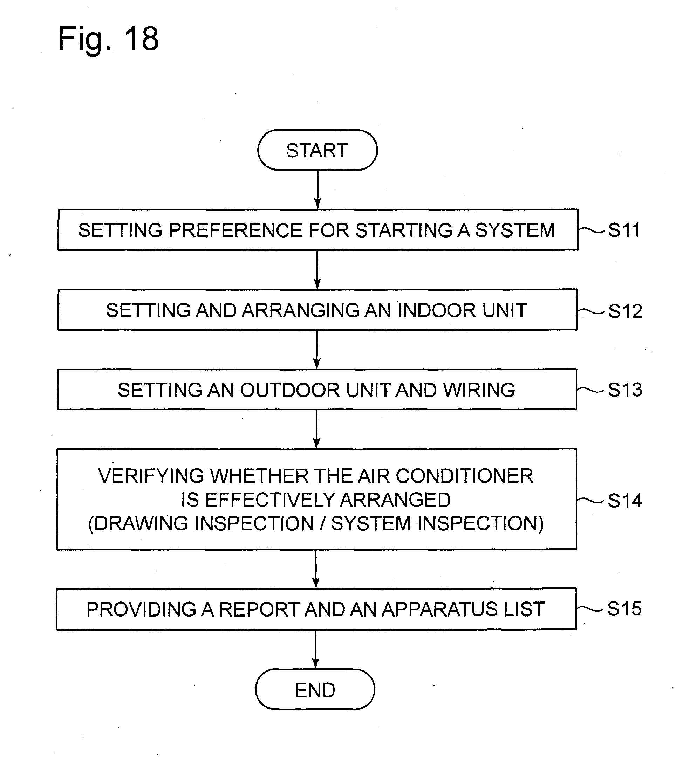

Fig. 17 is a block diagram illustrating a configuration of an installation guide system according to an embodiment of the present invention. Fig. 18 is a flowchart illustrating a method of using an installation guide for air conditioner according to an embodiment of the present invention.

Referring to Fig. 17, the installation guide system 10 includes an input unit 21 for inputting a predetermined command for an arrangement design of an air conditioner, a memory unit 23 for storing drawing information on a space where an air conditioner is to be installed, a display unit 20 for displaying a process for an arrangement design of the air conditioner, and a control unit 25 for controlling their configurations.

The input unit 21 may be a keyboard or a mouse of a computer. However, if a user command is inputted to the installation guide system 10, any form of an input unit may be possible.

The memory unit 23 may store drawing information including at least one structure among information on a building where an air conditioner is to be installed, floor information, and room information. Such drawing information may be delivered from a customer (such as a building owner and architect) and may be stored in the system 10. Also, in the process of designing the arrangement of an air conditioner, such drawing information may be displayed on the display unit 20.

Referring to Fig. 18, a method of using the installation guide system 10 will be described according to an embodiment of the present invention.

By executing a specific program, the display unit 20 displays the program. Then, startup environment information (or driving condition information) is configured by using a menu displayed on the display unit 20. Here, a method of configuring the startup environment of the system includes a process for generating a process (project) for installing an air conditioner, generating space information, and designating an area where the air conditioner is to be installed in operation S11.

Once the startup environment is configured, a process for arranging a detailed apparatus of the air conditioner, that is, an indoor unit, an outdoor unit, and other pipes, is performed.

### First the indoor unit is arranged.

In more detail, an indoor unit is selected as the type of product displayed on the product information displaying unit 300, and then, the type and model of the indoor unit are selected.

The indoor unit of the selected model may be automatically arranged on the drawing displaying unit 200. At this point, by selecting the automatic arrangement selecting unit 330, the automatic arrangement command of the indoor unit may be inputted. Then, on the basis of the message outputted to the command displaying unit 250, a room boundary for automatically arranging the indoor unit may be selected.

Then, on the basis of the area and load information of the room where the indoor unit is to be installed, the installation number of indoor units may be recommended, and once a user confirmation input is made, according to the inputted information, the indoor unit may be automatically installed on the drawing displaying unit in operation S12.

Next, an outdoor unit may be arranged. In more detail, an outdoor unit is selected as the type of product displayed on the product information displaying unit 300, and then, the type and model of the outdoor unit are selected.

Then, the outdoor unit of the selected model may be arranged at one point on the drawing displaying unit 200. As one example, when one point of the drawing displaying unit 200 is clicked using a mouse, the outdoor unit of the selected model may be inserted into the drawing displaying unit 200.

Once the arrangements of the indoor unit and the outdoor unit are made, a riser hole insertion point connecting a floor and another floor may be designated. Then, by selecting the wiring tool 358 of the edit toolbar displaying unit 350, the main pipe connected from the riser hole insertion point to the indoor unit may be drawn. As one example, straight or bending lines may be displayed on the drawing displaying unit 200 by using a mouse.

Once the main pipe line 262 is inserted on the drawing displaying unit 200, by inputting "smart wiring" on the command displaying unit 250, a branched pipe or a header, which is to be connected from the main pipe line 262 to the indoor unit, may be automatically inserted. Here, the header may be understood as a component coupled to the branched pipe to guide the branching of a refrigerant in operation S13.

In such a manner, when an apparatus (an indoor unit, an outdoor unit, and a pipe) of an air conditioner is inserted, a system inspection may be made on whether an arrangement design of an air conditioner is made effectively.

First, drawing inspection is made on whether apparatuses and pipes inserted on the drawing displaying unit 200 are effectively connected, that is, the crated drawing. The drawing inspection may be performed by selecting the drawing inspection selecting unit 152 of the control toolbar displaying unit 150.

When the drawing inspection selecting unit 152 is selected, in order to confirm whether a refrigerant pipe or a drain pipe is effectively arranged, the detailed structure of the drawing may be displayed. The detailed structure is a tree structure to easily confirm a connection relationship from an outdoor unit to a riser hole and an indoor unit in operation S14.

Also, the effectiveness inspection of the system, that is, effectiveness inspection/verification, may be made in order to confirm a verification result of a system for each apparatus. The effectiveness inspection/verification may be performed by selecting the system inspection selecting unit 153 of the control toolbar displaying unit 150.

Once the system inspection selecting unit 153 is selected, a list of apparatuses constituting an air conditioner is displayed on the basis of an outdoor unit, and by inputting a "system analysis" command, verification is made on whether the combination ratio and cooling and heating capacity of an outdoor unit and an indoor unit are appropriate. Also, verification may be made on whether information values relating to the length of a pipe or the height of an outdoor unit (indoor unit) constituting an air conditioner are within the limit value.

Also, once the drawing and system effectiveness inspections are completed, a report and an apparatus list including information on the verification result may be inputted in operation S15.

Thus, by using the installation system 10, a design relating to the apparatus selection and arrangement of an air conditioner may be easily made, so that the installation of an air conditioner is effectively provided.

According to an embodiment, in relation to an installation guide system of an air conditioner, the installation environment of a building is stored from an actual drawing relating to the building, and according thereto, the selection or arrangement of an air conditioner proper for the stored installation environment can be made. Therefore, an air conditioner optimized for a building's environment can be installed.

Additionally, on the basis of building space information and usage information (for example, generated calorie information), necessary cooling and heating capacity is calculated, and the number of indoor units to be used and the capacity of an outdoor unit are determined. Therefore, an installation process of an air conditioner can be easy.

Additionally, after a simulation on the installation of an air conditioner is completed, the drawing and system inspection process are performed. Therefore, whether installation information on the designed air conditioner is appropriate can be verified. If the installation information is not proper, a corresponding error can be confirmed and edited.

Additionally, since installation information on the designed and verified air conditioner is provided to a customer (for example, a building owner or an installation shop) in a report form (for example, Installation reports and apparatus schedules), the customer can easily confirm the installation information of the air conditioner.

Additionally, as an installation guide system of an air conditioner is provided as a drawing program, a designer can easily manipulate it. In more detail, a main menu that you can see installation information and product information at a glance is displayed on a display unit of the system, and a result that a detailed menu of the main menu is selected can be confirmed in the drawing. Therefore, a design process can be accurately performed.

According to an embodiment, in relation to an installation guide system of an air conditioner, the installation environment of a building is stored from an actual drawing relating to the building, and according thereto, the selection or arrangement of an air conditioner proper for the stored installation environment can be made. Therefore, an air conditioner optimized for a building's environment can be installed, and also industrial applicability is considerable.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A method of using an installation guide system (10) for air conditioner, the method comprising:
executing predetermined information to use the installation guide system for air conditioner;
displaying a display unit (20) including a drawing displaying unit (200);
configuring driving condition information on the installation guide system;
arranging apparatuses constituting an air conditioner on the drawing displaying unit (200); and
verifying whether the air conditioner is effectively arranged.

2. The method according to claim 1, wherein the configuring of the driving condition information comprises at least one of:
generating information on a space where the air conditioner is to be installed; and
designating an area of the space where the air conditioner is to be installed.

3. The method according to claim 2, wherein the information on the space comprises at least one of information on a building where the air conditioner is to be installed, information on floors constituting the building, and information on rooms constituting the floors.

4. The method according to claim 3, wherein the building, the floors, or the rooms are available for addition and deletion.

5. The method according to any of claims 2 to 4, wherein generating information on the space comprises displaying pre-determined building drawing information on the drawing displaying unit (200).

6. The method according to any of claims 2 to 5, wherein the designating of the area of the space where the air conditioner is to be installed comprises designating a boundary area of a floor or a room in the drawing information displayed on the drawing displaying unit (200).

7. The method according to any of the preceding claims, wherein the arranging of the apparatus on the drawing displaying unit (200) comprises arranging at least one product of an indoor unit, an outdoor unit, and a pipe on the drawing displaying unit.

8. The method according to claim 7, wherein the arranging of the indoor unit on the drawing displaying unit (200) comprises:
determining a type of the indoor unit; and
automatically arranging the indoor unit of the determined type on the drawing displaying unit (200).

9. The method according to claim 8, wherein the automatically arranging of the indoor unit comprises recommending the installation number of indoor units on the basis of the information on the space where the indoor unit is to be installed.

10. The method according to any of claims 7 to 9, wherein the arranging of the outdoor unit on the drawing displaying unit (200) comprises:
determining a type of the outdoor unit; and
designating a place where the outdoor unit is to be arranged on the drawing displaying unit (200).

11. The method according to any of claims 7 to 10, wherein the arranging of the pipe on the drawing displaying unit (200) comprises:
displaying a main pipe that extends from the outdoor unit to an area where the indoor unit is arranged; and
designating an arrangement area including the indoor unit to which the main pipe is connected.

12. The method according to claim 11, wherein the arranging of the pipe on the drawing displaying unit (200) further comprises:
extending a branched pipe from the main pipe toward the indoor unit; and
arranging a branched part at a place where the branched pipe is branched from the main pipe.

13. The method according to any of the preceding claims, wherein the verifying of whether the air conditioner is effectively arranged comprises:
performing a drawing inspection process for inspecting whether a design drawing of the air conditioner on the drawing displaying unit (200) is effectively created.

14. The method according to claim 13, wherein the performing of the drawing inspection process comprises displaying a structure relating to a refrigerant structure connecting the apparatuses of the air conditioner, a drain structure for drainage, or a control structure.

15. The method according to any of the preceding claims, wherein the verifying of whether the air conditioner is effectively arranged comprises performing a system inspection process for inspecting effectiveness of each apparatus, wherein the system inspection process includes:
displaying information relating to positions or capacities of the apparatuses constituting the air conditioner; and
recognizing whether the information relating to positions or capacities of apparatuses is within a limit value range of reference information.
